# EUROPEAN PATENT SPECIFICATION

(11) **EP 2 779 454 B1**
(45) Date of publication and mention of the grant of the patent: **21.03.2018**
(21) Application number: 13185367.3
(22) Date of filing: 20.09.2013
(51) Int. Cl.: H03K 17/22, G06F 1/26

(54) **Sensor having a power reset and a load drive circuit**
Sensor mit einer Reset-Schaltung und Lasttreibersschaltung
Capteur avec circuit de réinitialisation de mise sous tension et circuit de commande de charge

(30) Priority: 15.03.2013 JP 2013054269
(43) Date of publication of application: 17.09.2014
(73) Proprietor: OMRON Corporation, Shiokoji-dori, Shimogyo-Ku Kyoto-shi Kyoto 600-8530 (JP)
(72) Inventor: Miyamoto, Kazuaki, Kyoto, Kyoto 600-8530 (JP); Kawai, Takehiro, Kyoto, Kyoto 600-8530 (JP); Serrano-Gotarredona, Rafael, 46021 Valencia (ES)
(74) Representative: Horn Kleimann Waitzhofer Patentanwälte PartG mbB

(56) References cited:
- JP-A- S56 166 637
- JP-A- 2007 235 487
- US-A1- 2002 021 150
- US-A1- 2007 115 061

## Description

### TECHNICAL FIELD

The present invention relates to a sensor, and more particularly, to a sensor with a power reset circuit.

### RELATED ART

When power of a sensor is turned on, the sensor may cause incorrect detection because of, for example, the rising characteristics of a power supply voltage. A power reset circuit, which inhibits the output of a sensor for a predetermined period of time after the power has been turned on, is conventionally used in the sensor.

For example, JP 62-214720 A discloses a power reset circuit used in a proximity sensor. The power reset circuit is intended to prevent chattering during the disabling or operation of the power reset in a three-wire type sensor.

For example, JP 2-177612 A also discloses a power reset circuit in a DC two-wire type sensor. The power reset circuit includes a voltage detection circuit, a timer circuit, an output inhibit circuit, and a hysteresis circuit. The voltage detection circuit detects that a power supply voltage has reached a first predetermined value and outputs a detection signal. The timer circuit starts to count a power reset time in response to an output signal of the voltage detection circuit. The output inhibit circuit outputs an output inhibit signal in response to the output signal of the voltage detection circuit. The output inhibit circuit disables the output inhibit signal in response to a timer output from the timer circuit when the timer circuit has counted the power reset time. The hysteresis circuit changes the detection reference voltage of the voltage detection circuit to a second predetermined value lower than the first predetermined value in response to the output signal thereof.

A conventional sensor suppresses the fluctuation of power supply voltage and absorbs noise from outside, for example, using a smoothing capacitor. In order to further prevent noise with a large surge width from affecting the supply voltage, the smoothing capacitor and a resistor inserted in a power line constitute an integrating circuit.

However, a circuit for stabilizing the supply voltage may affect the stability of the transient operation of a sensor when the power of the sensor is turned on or turned off.

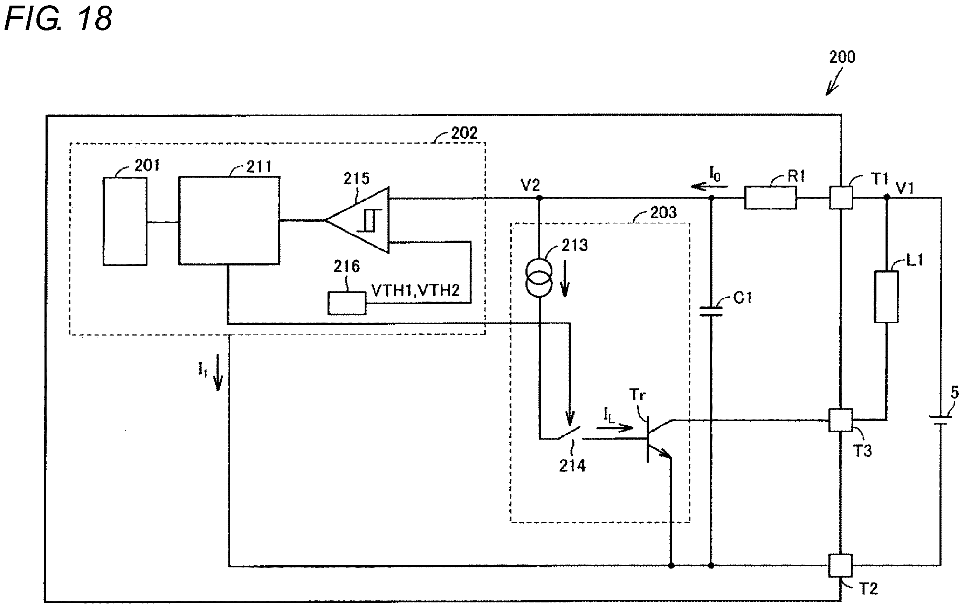

Fig. 18 is a block diagram showing a schematic configuration of a sensor with a conventional power reset circuit. Referring to Fig. 18, a sensor 200 includes a main circuit 202, an output circuit 203, a resistor R1, a smoothing capacitor C1, a power supply terminal T1, a ground terminal T2, and an output terminal T3. The main circuit 202 includes a detection circuit 201, a control circuit 211, a hysteresis comparator 215, and a threshold voltage generating circuit 216. The output circuit 203 includes a current source 213, a transistor Tr, and a switching circuit 214.

The power supply terminal T1 and the ground terminal T2 are connected to the positive electrode and the negative electrode of a power supply 5, respectively, and a voltage V1 is applied between the power supply terminal T1 and the ground terminal T2.

One end of the resistor R1 is connected to the power supply terminal T1. The other end of the resistor R1 is connected to one input terminal of the hysteresis comparator 215. The smoothing capacitor C1 is connected between the other end of the resistor R1 and the ground terminal T2. The resistor R1 and the smoothing capacitor C1 constitute a noise filter.

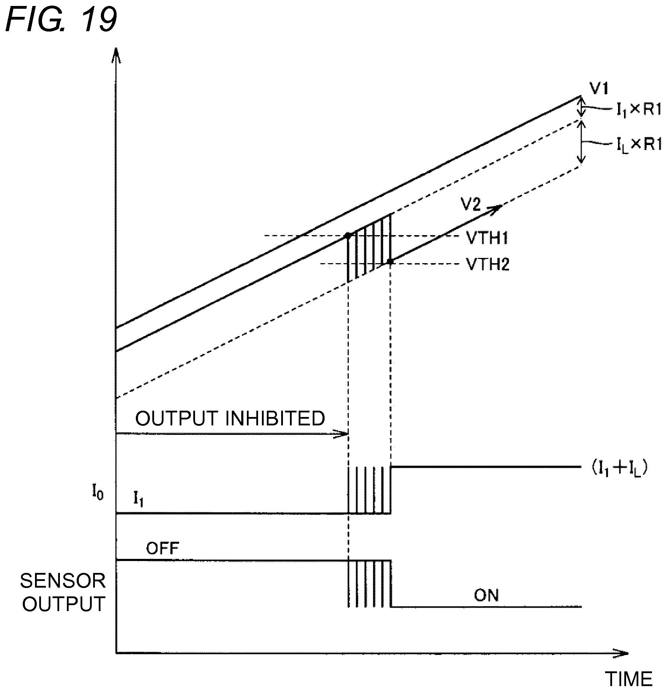

A load L1 is connected to the sensor 200. For the NPN output, the load L1 is connected between the power supply terminal T1 and the output terminal T3. The transistor Tr is an NPN transistor as shown in Fig. 19. The collector, base, and emitter of the NPN transistor are connected to the output terminal T3, the switching circuit 214, and the ground terminal T2, respectively. The load L1 connected to the output terminal T3 is driven based on the sensing results of the sensor 200.

The detection circuit 201 is connected to the control circuit 211. The control circuit 211 turns on the switching circuit 214. This allows a current IL to be supplied from the current source 213 to the base of the transistor Tr, and the transistor Tr is driven. A current I1 flows from the main circuit 202 to the ground terminal T2

Fig. 19 is a timing diagram showing the operation of the sensor 200 in Fig. 18, during power-up. Referring to Figs. 18 and 19, when the power of the sensor 200 is turned on, a current consumption 10 required in the sensor 200 flows from the power supply 5 through the main circuit 202 to the ground (GND) line. At this time, the current consumption 10 is equal to the current I1.

The resistor R1 causes a voltage drop. The voltage drop is represented by: (10 × R1) = (I1 × R1). Accordingly, a voltage V2 input to the main circuit 202 is lower than the power supply voltage V1 by (I1 × R1). The sensor 200 inhibits the output for a certain period immediately after the power has been turned on until the voltage V2 reaches a threshold voltage VTH1. Such an output inhibit period can prevent a signal indicating a detection result from being erroneously output from the sensor 200 in a transient period immediately after the power has been turned on.

The output inhibit period is terminated by the voltage V2 reaching the threshold voltage VTH1 (power reset voltage). If work exists, the sensor 200 is output-enabled, and in this case, the sensor 200 drives the load L1 by driving the transistor Tr.

In order to drive the transistor Tr, the main circuit 202 turns on the switching circuit 214 and supplies the current IL to the base of the transistor Tr. The current consumption 10 of the sensor changes from the current I1 to a current (I1 + IL). A voltage drop across the resistor R1 is therefore {(I1 + IL) × R1}. That is, driving the transistor Tr reduces the voltage V2, and the voltage V2 falls below the threshold voltage VTH1.

The power reset voltage is provided with a hysteresis width such that the internal circuitry of the sensor 200 does not simply reset the power (turn off the output) again even if a voltage drop due to the current variation or noise occurs. A voltage corresponding to the lower limit of the hysteresis width is a threshold voltage VTH2 (power re-reset voltage). The hysteresis width (VTH1 - VTH2) is set to be equal to or greater than the voltage drop of an external circuit or the voltage variation due to noise. This can prevent the power re-reset even if the voltage V2 drops due to the variation of the current consumption in the sensor 200.

However, if the current IL is large or the hysteresis width is small, the voltage V2 is reduced to a value equal to or lower than the threshold voltage VTH2 due to a voltage drop of (IL × R1). In this case, the sensor 200 inhibits the output. That is, the main circuit 202 turns off the switching circuit 214 and stops the driving of the transistor Tr. This results in no current IL, and a voltage drop of (I1 × R1) occurs across the resistor R1. Thus, the voltage V2 exceeds the threshold voltage VTH1 again.

When the voltage V2 exceeds the threshold voltage VTH1 again, the sensor 200 becomes output-enabled. The presence of the work allows the sensor 200 to drive the transistor Tr and to output a signal indicating the detection result. The voltage V2 is thus reduced. That is, a state in which the voltage V2 exceeds the threshold voltage VTH1 and a state in which the voltage V2 falls below the threshold voltage VTH2 are alternately repeated. In this case, the output of the sensor 200 chatters.

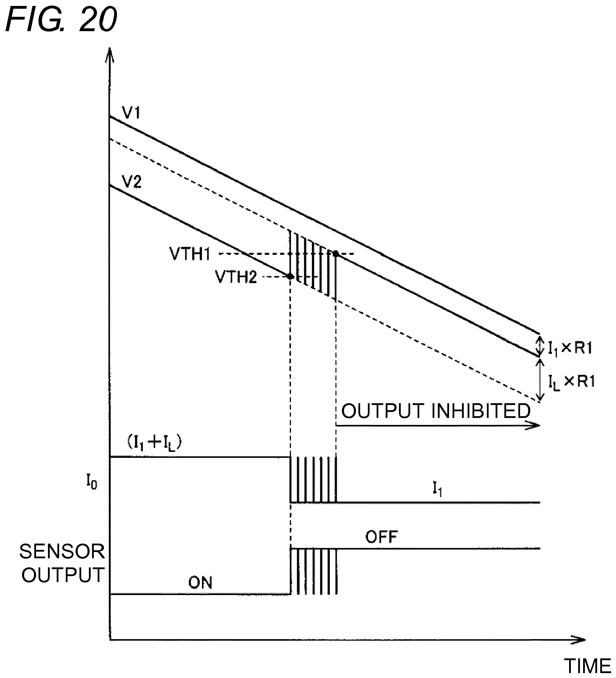

Fig. 20 is a timing diagram showing the operation of the sensor 200 in Fig. 18, during power-down. Referring to Figs. 18 and 20, the voltage V2 decreases with a decrease of the voltage V1. When the voltage V2 falls below the threshold voltage VTH2, the main circuit 202 stops the driving of the transistor Tr. Therefore, no voltage drop of (IL × R1) occurs across the resistor R1, and the voltage V2 rises. Thus, the voltage V2 exceeds the threshold voltage VTH1. In this case, the sensor 200 becomes output-enabled and drives the transistor Tr again. When the sensor 200 is output-enabled, the voltage V2 decreases.

That is, also during power-down, a state in which the voltage V2 exceeds the threshold voltage VTH1 and a state in which the voltage V2 falls below the threshold voltage VTH2 are alternately repeated. Also in this case, the output of the sensor 200 chatters.

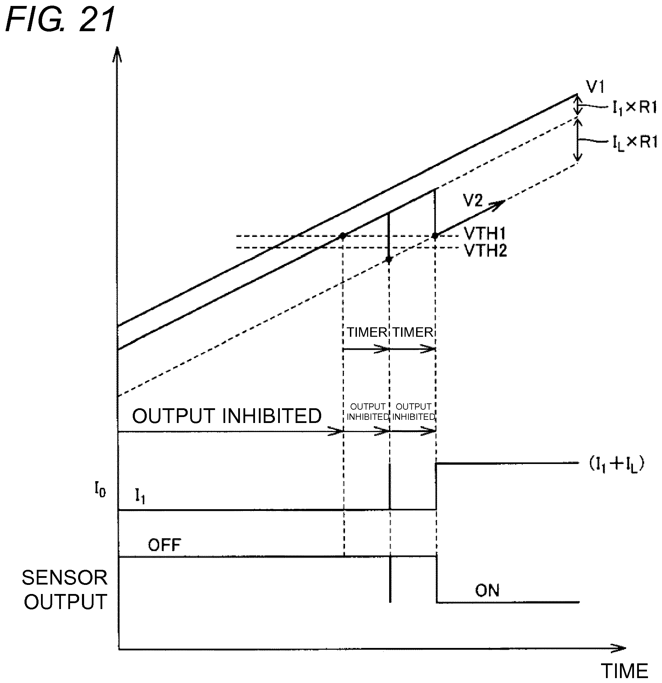

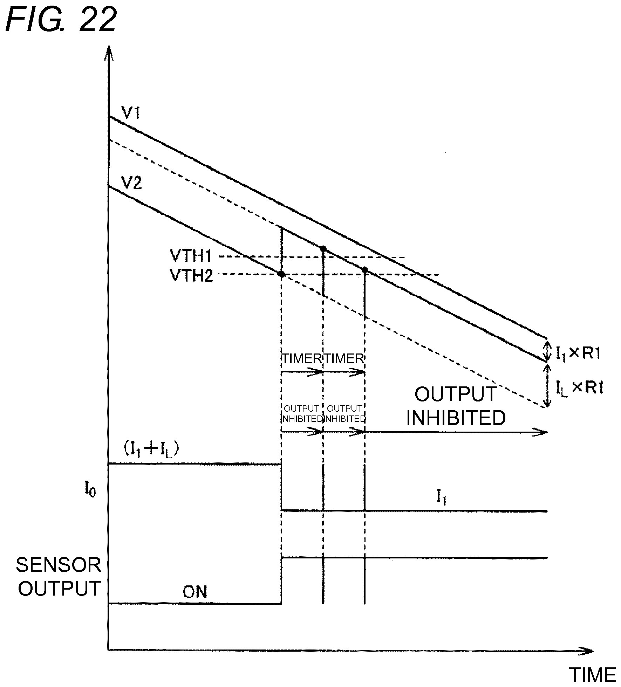

Fig. 21 is a diagram showing an improved example of the operation in Fig. 19. Fig. 22 is a diagram showing an improved example of the operation in Fig. 20. Referring to Figs. 21 and 22, a timer measures a certain time from when the voltage V2 exceeds the threshold voltage VTH1 during power-up. The output of the sensor is inhibited during the timer measurement. After the certain time has elapsed, the sensor 200 is output-enabled.

If the voltage V2 exceeds the threshold voltage VTH1 at the time when the timer measurement has been completed, the sensor 200 remains output-enabled. As a result, the output circuit is operated, but the sensor is reset again to be in an output inhibiting state when the voltage V2 falls below the threshold voltage VTH2 due to a voltage drop. As a result, no voltage drop occurs and the timer is restarted when the voltage V2 exceeds the threshold voltage VTH1 again. Until the voltage V2, at which the output circuit is operated after completion of the timer measurement, exceeds the threshold voltage VTH2, the timer is repeatedly started and the sensor output is inhibited.

Such an operation can prevent continuous chattering. However, until the voltage V2 after the output circuit is driven exceeds the threshold voltage VTH2, the sensor produces an error output each time the timer expires. As the rise of a power supply voltage (voltage V1) is slower, the number of start-ups of the timer increases. The sensor thus produces error outputs.

Similarly in the case shown in Fig. 22, the sensor output is inhibited once the voltage V2 falls below the threshold voltage VTH2. As a result, no voltage drop occurs and the voltage V2 rises.

When the voltage V2 exceeds the threshold voltage VTH1, the timer operates again. The timer is repeatedly started until the voltage V2 after the output is inhibited falls below the threshold voltage VTH1. At the same time, if the voltage V2 after completion of the timer measurement is equal to or above the threshold voltage VTH2, the output circuit is driven and the sensor produces an error output.

Such an error output of the sensor is caused by a large voltage drop of (IL × R1) across the resistor R1. It is therefore contemplated to reduce the value of the resistor R1. However, when the value of the resistor R1 is reduced, the time constant of the noise filter (integrating circuit) configured by the resistor R1 and the smoothing capacitor C1 becomes smaller, and this reduces the effect of removing noise. Circuit constants to be set are also different depending on the shape of a sensor or noise immunity required. Thus, identifying an appropriate value of the resistor R1 is also difficult.

Furthermore, in recent years, a protection component that can be mounted on a sensor is restricted due to demand for smaller or low-cost sensors. Accordingly, an integrating circuit consisting of a line resistor and a smoothing capacitor tends to be employed to reduce costs without using a Zener diode or surge absorber having high noise absorbency. Increasing the effect of noise removal using the integrating circuit requires, for example, a higher resistance. However, the higher resistance causes a problem of error output of the sensor.

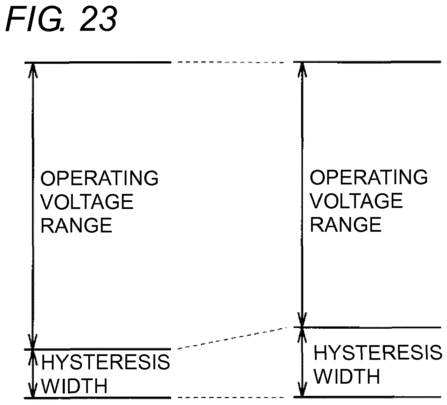

It is contemplated as another method of preventing the error output of the sensor to increase a voltage hysteresis width. In this case, however, a problem shown in Fig. 23 occurs. That is, increasing the voltage hysteresis width is to increase the lower limit of an operating voltage range. The operating voltage range is therefore narrowed. Power-up speed of a user is also varied, and setting the optimum hysteresis width is difficult.

Thus, in the conventional configuration, a voltage change exceeding the hysteresis width to control a sensor to enter an output-enabled state and an output inhibit state occurs during power-up or power-down. This intrinsically causes a problem that a sensor produces an error output when the power supply voltage rises or falls.
US 2002/021150 A1 discloses a load drive circuit in which a charge pump circuit inputs a battery voltage of a power line and outputs a raising voltage proportional to the battery voltage. A low voltage detecting circuit detects a low voltage state in which a detecting voltage obtained by dividing the raising voltage is lower than a reference voltage. Thus, it is possible to indirectly detect a low voltage state in which the battery voltage is lower than a predetermined threshold value. When the low voltage state is detected, a drive circuit turns off a MOSFET. At this time, the battery voltage is temporarily varied, but the charge pump circuit has a filter action and a delay action, whereby temporary variation does not easily appear in the raising voltage (detecting voltage), and an error in operation of the MOSFET can be prevented.
In US 2007/115061 A1, a device for voltage-noise rejection and fast start-up is provided. It comprises a low-pass filter connected to a voltage source, a voltage-controlled switch connected in parallel with the low-pass filter, and an auxiliary start-up element connected to a DC-only voltage output. By using a transistor operating in the triode region and a capacitor with suitable capacitance, it is suitable for integration to form a low-frequency low-pass pole to suppress the noise in the reference current. The auxiliary start-up element overcomes the large turn on time caused by the low frequency low-pass pole. As there is no static current during normal operation, the power consumption for the device is low.

### SUMMARY

An object of the present invention is to prevent a sensor from producing an error output due to power reset in a transient state such as when power of the sensor is turned on or turned off.

This object is achieved by a sensor according to claim 1.

According to the present invention, a sensor can normally start or stop while the error output of the sensor is prevented when the power of the sensor is turned on or turned off.

### BEIEF DESCRIPTION OF THE DRAWINGS

Fig. 1 is a block diagram showing a schematic configuration of a sensor of a first embodiment;
Fig. 2 is a diagram illustrating an example of a specific configuration of the circuit shown in Fig. 1;
Fig. 3 is a timing diagram illustrating the operation of a sensor 101 of the first embodiment during power-up;
Fig. 4 is a timing diagram illustrating the operation of the sensor 101 of the first embodiment during power-down;
Fig. 5 is a timing diagram illustrating the operation of the sensor 101 during power-up in the case where a time lag exists between the operations of two switches SW1 and SW2;
Fig. 6 is a timing diagram illustrating the operation of the sensor 101 during power-down in the case where a time lag exists between the operations of two switches SW1 and SW2;
Fig. 7 is a diagram illustrating another exemplary configuration of the sensor of the first embodiment;
Fig. 8 is a timing diagram illustrating the operation of a sensor 101A shown in Fig. 7 during power-up;
Fig. 9 is a block diagram showing a schematic configuration of a sensor of a second embodiment;
Fig. 10 is a diagram illustrating an example of a specific configuration of the circuit shown in Fig. 9;
Fig. 11 is a block diagram showing a schematic configuration of a sensor of a third embodiment;
Fig. 12 is a diagram illustrating an example of a specific configuration of the circuit shown in Fig. 11;
Fig. 13 is a block diagram showing a schematic configuration of a sensor of a fourth embodiment;
Fig. 14 is a diagram illustrating an example of a specific configuration of the circuit shown in Fig. 13;
Fig. 15 is a timing diagram illustrating the operation of a sensor 103 shown in Fig. 14 during power-up;
Fig. 16 is a block diagram showing a schematic configuration of a sensor of a fifth embodiment;
Fig. 17 is a block diagram illustrating the operation of a sensor 105 in the case where a PNP transistor Tr2 is used as a varying current load 12;
Fig. 18 is a block diagram showing a schematic configuration of a sensor with a conventional power reset circuit;
Fig. 19 is a timing diagram showing the operation of a sensor 200 in Fig. 18 during power-up;
Fig. 20 is a timing diagram showing the operation of the sensor 200 in Fig. 18 during power-down;
Fig. 21 is a diagram showing an improved example of the operation in Fig. 19;
Fig. 22 is a diagram showing an improved example of the operation in Fig. 20; and
Fig. 23 is a diagram for illustrating a problem of a wider voltage hysteresis width.

### DETAILED DESCRIPTION

Embodiments of the present invention will now be described with reference to the drawings. In the following description, the same components are denoted by the same reference numerals, and detailed descriptions thereof are not repeated.

### First Embodiment

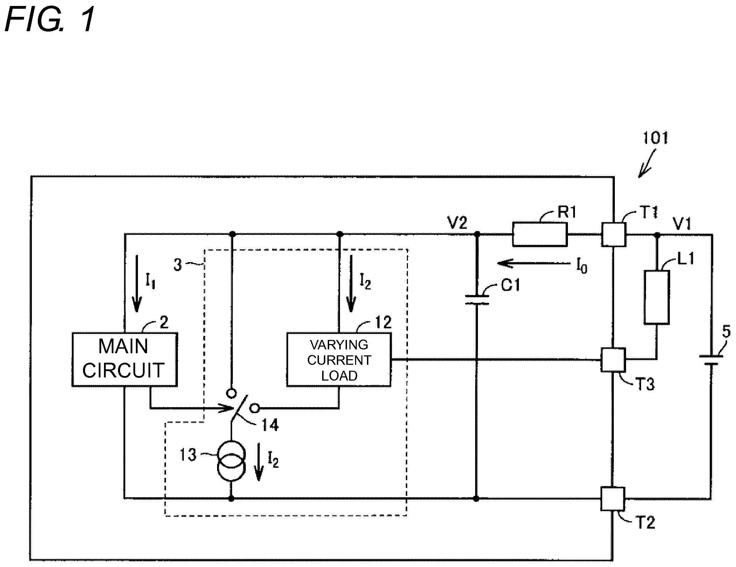

Fig. 1 is a block diagram showing a schematic configuration of a sensor of a first embodiment. Referring to Fig. 1, a sensor 101 of the first embodiment includes a main circuit 2, an output circuit 3, a resistor R1, a smoothing capacitor C1, a power supply terminal T1, a ground terminal T2, and an output terminal T3. The output circuit 3 includes a varying current load 12, a current source 13, and a switching circuit 14.

The power supply terminal T1 and the ground terminal T2 are connected to a positive electrode and a negative electrode of a power supply 5, respectively, and a voltage V1 is applied between the power supply terminal T1 and the ground terminal T2.

One end of the resistor R1 is connected to the power supply terminal T1 for the NPN type, for example. The other end of the resistor R1 is connected to the main circuit 2. The smoothing capacitor C1 is connected between the other end of the resistor R1 and the ground terminal T2. The resistor R1 and the smoothing capacitor C1 constitute a noise filter.

A load L1 is connected to the sensor 101. That is, the load L1 is an external load in the outside of the sensor 101. For example, for the NPN output, the load L1 is connected between the power supply terminal T1 and the output terminal T3, as shown in Fig. 1. Specifically, the load L1 is a resistance element. The load L1 connected to the output terminal T3 is driven based on the sensing results of the sensor 101.

The main circuit 2 includes a detection circuit (not shown), and detects a detection target to generate an electrical signal. The sensing method of the detection circuit is not particularly limited, and for example, sensing methods using optics, magnetism, and sound may be employed. In addition, the detection circuit is not limited to detect a specific detection target.

Further, the main circuit 2 controls the switching circuit 14. A current I1 flows through the main circuit 2 such that the main circuit 2 performs these operations.

The current source 13 is configured to supply a constant current 12. The switching circuit 14, which is controlled by the main circuit 2, switches whether to connect the current source 13 between the other end of the resistor R1 and the ground terminal T2 or to connect it between the varying current load 12 and the ground terminal T2. The connection of the current source 13 between the varying current load 12 and the ground terminal T2 allows the constant current 12 to flow through the varying current load 12. The constant current 12 flowing through the current source 13 is equal to the current flowing through the varying current load 12 when the varying current load 12 operates.

The varying current load 12 is connected to the load L1 through the output terminal T3. Upon operation of the main circuit 2 (upon detection of the detection target), the constant current 12 flows from the power supply 5 through the resistor R1 to the varying current load 12. This allows the varying current load 12 to drive the load L1, and the voltage at the output terminal T3 changes. That is, the varying current load 12 is a drive circuit for driving the load L1. The constant current 12 is the drive current flowing through the varying current load 12 (drive circuit).

Although not shown in Fig. 1, the sensor 101 may further include a Zener diode for overvoltage protection. The Zener diode is connected in parallel with the smoothing capacitor C1 so as to reverse the direction from the power supply terminal T1 to the ground terminal T2, for example. Alternatively, the sensor 101 may be provided with a diode mounted on the ground line. The forward direction of the diode is toward the ground terminal T2. This diode is configured to prevent failure of the sensor 101 when the power supply terminal T1 and the ground terminal T2 are connected in opposite polarity to the power supply 5.

Switching between the driving and stopping of the sensor 101 changes the current flowing through the varying current load 12. The amount of change is 12. The main circuit 2 and the output circuit 3 are configured to cancel the current variation. Specifically, when the sensor 101 is stopped (no sensor output is generated), the main circuit 2 controls the switching circuit 14 and connects the current source 13 to the resistor R1. In this case, the constant current 12 flows from the power supply 5 through the resistor R1 and the current source 13 to the ground. On the other hand, when the sensor 101 is operated (output-enabled), the main circuit 2 controls the switching circuit 14 and connects the current source 13 to the varying current load 12. In this case, the current source 13 is connected to the varying current load 12 (drive circuit) at downstream of the drive current. The constant current 12 flows from the power supply 5 through the resistor R1 and the current source 13 to the varying current load 12. The varying current load 12 drives the load L1 using the constant current 12 as the drive current. That is, the switching circuit 14 switches between a state (first state) in which the varying current load 12 drives the load L1 and a state (second state) in which the constant current flows to the ground.

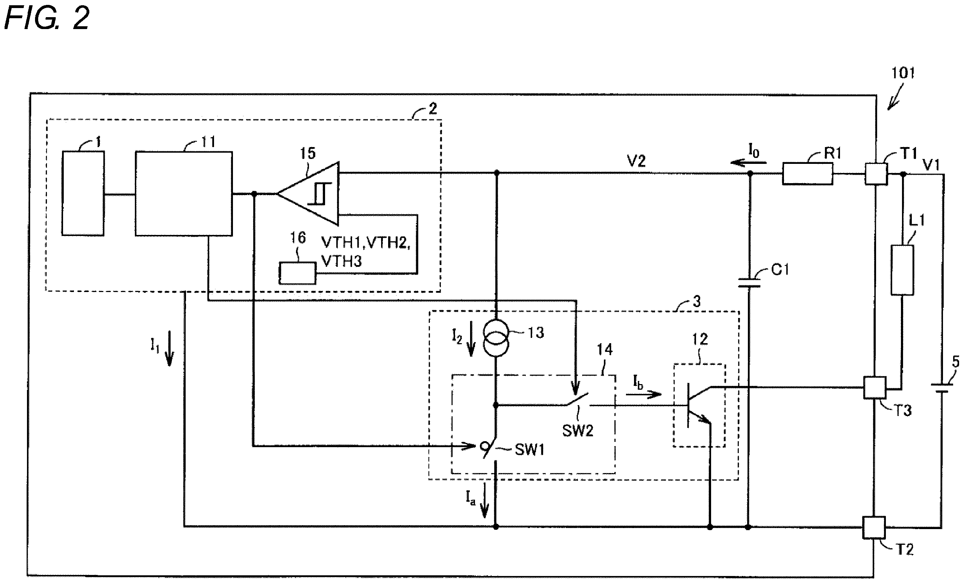

Fig. 2 is a diagram illustrating an example of a specific configuration of the circuit shown in Fig. 1. Referring to Figs. 1 and 2, a switching element typified by a transistor is used as the varying current load 12 (the same applies to embodiments described below). As shown in Fig. 2, the varying current load 12 is provided, for example, as an NPN transistor. The collector, base, and emitter of the NPN transistor are connected to the output terminal T3, the switching circuit 14, and the ground terminal T2, respectively.

The main circuit 2 includes a detection circuit 1, a control circuit 11, a hysteresis comparator 15, and a threshold voltage generating circuit 16. The hysteresis comparator 15 compares a voltage V2 with threshold voltages VTH1, VTH2, and VTH3. The output of the hysteresis comparator 15 is sent to the control circuit 11 and the switching circuit 14. The detection circuit 1 is connected to the control circuit 11.

The switching circuit 14 has a switch SW1 and a switch SW2. The switch SW1, which is connected between the current source 13 and the ground terminal T2, is turned on and off by the output of the hysteresis comparator 15 so that the switch SW1 switches whether to connect the current source 13 to the ground. A current that flows from the other end of the resistor R1 through the current source 13 to the ground terminal T2 when the switch SW1 is turned on is referred to as Ia.

The switch SW2, which is connected between the current source 13 and the base of a transistor Tr, is turned on and off by the output of the control circuit 11 so that the switch SW2 switches whether to connect the current source 13 to the varying current load 12. A current flowing through the current source 13 to the base of the transistor Tr when the switch SW2 is turned on is referred to as Ib.

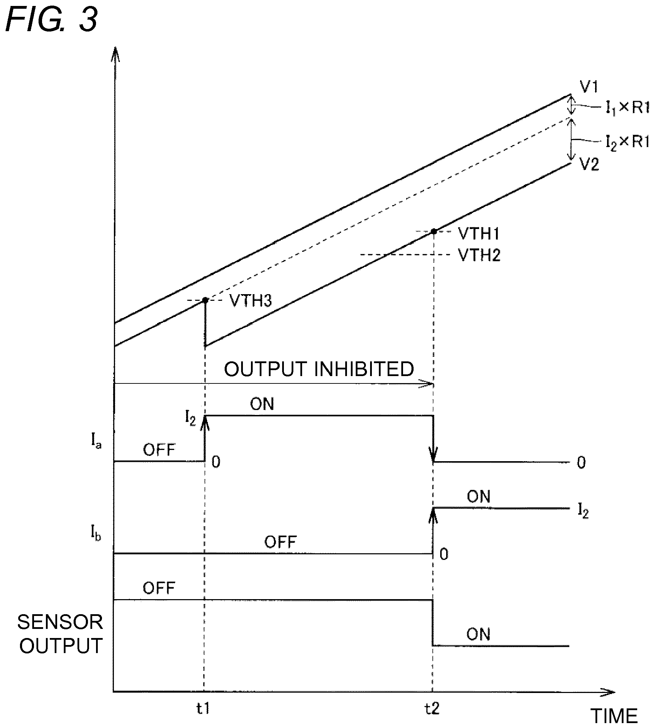

Fig. 3 is a timing diagram illustrating the operation of the sensor 101 of the first embodiment during power-up. Referring to Figs. 2 and 3, three levels of the threshold voltages (VTH1, VTH2, and VTH3) are set for the voltage V2.

The voltage V1 rises by activating the power supply 5. At this time, a current consumption 10 of the sensor 101 is equal to the current I1.Thus, a current flowing through the resistor R1 is I1.The switches SW1 and SW2 are turned off so that no drive current flows through the varying current load 12, and no constant current flows through the current source 13. The voltage V2 is lower than the voltage V1 by (I1 × R1). Until the voltage V2 reaches the threshold voltage VTH3, the voltage V2 rises while maintaining a state in which the voltage V2 is lower than the voltage V1 by (I1 × R1).

The voltage V2 reaches the threshold voltage VTH3 at time t1. In one embodiment, the threshold voltage VTH3 may be a minimum drive voltage of the main circuit 2. The output of the hysteresis comparator 15 turns on the switch SW1. This allows the current Ia equal to the current 12 to flow. The sensor output at this time is maintained at a high impedance. That is, the output of the sensor 101 is in an inhibited state.

As the current consumption 10 of the sensor changes from I1 to (I1 + 12), the voltage V2 decreases by a voltage drop of (R1 × I2) corresponding to an increase (current 12) in the current consumption of the sensor. Until the voltage V2 reaches the threshold voltage VTH1, the voltage V2 rises while maintaining a state in which the voltage V2 is lower than the voltage V1 by {(I1 + 12) × R1).

The voltage V2 then reaches the threshold voltage VTH1 at time t2, and the sensor 101 becomes operation-enabled (output-enabled). If the detection target is present within the detection range of the sensor 101, the sensor 101 is operated so that a voltage at the output terminal T3 changes. That is, the output of the sensor 101 changes from OFF to ON.

The output of the hysteresis comparator 15 turns off the switch SW1 at time t2, while the output of the control circuit 11 turns on the switch SW2. Thus, a current flowing from the current source 13 switches from Ia to Ib. Since Ia = Ib = 12, there is no increase or decrease in the current consumption of the sensor 101. The magnitude of the voltage drop across the resistor R1 does not change as a result.

According to this embodiment, the voltage V2 does not decrease to a value equal to or lower than the threshold voltage VTH2 after passing through a hysteresis width (voltage width from the threshold voltage VTH1 to the threshold voltage VTH2). In other words, once the voltage V2 has passed through the hysteresis width when the input voltage V2 of the main circuit 2 rises, the main circuit 2 inhibits the voltage V2 from returning to the hysteresis width by controlling the switching circuit 14. This can prevent the voltage V2 from falling below the threshold voltage VTH2. Thus, the power reset or re-reset of the sensor 101 can be prevented.

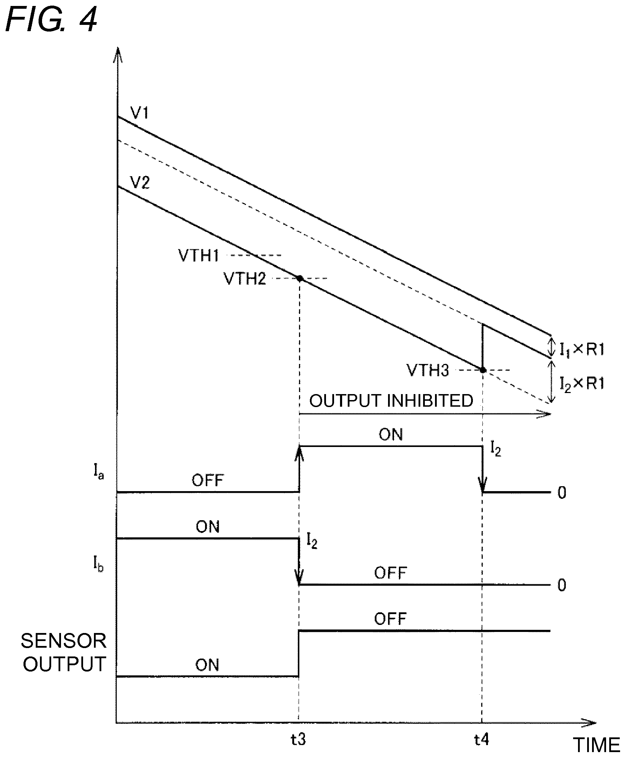

Fig. 4 is a timing diagram illustrating the operation of the sensor 101 of the first embodiment during power-down. Referring to Figs. 2 and 4, the voltage V1 of the power supply 5 decreases. When the output circuit operates, the voltage V2 decreases while maintaining a state in which the voltage V2 is lower than the voltage V1 by {(I1+ I2) × R1)}.

The voltage V2 reaches the threshold voltage VTH2 at time t3. The switch SW2 is turned off by the control circuit 11, and the current Ib does not flow. That is, the output of the sensor 101 is turned off. Also at time t3, the output of the hysteresis comparator 15 turns on the switch SW1. Thus, the current Ia flows. Since Ia = Ib = 12 as described above, the current consumption 10 of the sensor 101 remains to be (I1 + I2).

The voltage V2 decreases even after time t3. The voltage V2 reaches the threshold voltage VTH3 at time t4. The output of the hysteresis comparator 15 turns off the switch SW1, and the main circuit 2 turns off the switch SW2. Since this does not allow a drive current to flow through the varying current load 12, and also does not allow the current 12 to flow through the current source 13, no voltage drop of (I2 × R1) occurs across the resistor R1. Thus, the voltage V2 rises at time t4 and is lower than the voltage V1 by (I1 × R1), where the voltage V2 is lower than the threshold voltage VTH2. That is, once the voltage V2 has passed through the hysteresis width also when the input voltage V2 decreases, the main circuit 2 inhibits the voltage V2 from returning to the hysteresis width. Thus, the sensor 101 can prevent the power reset or re-reset.

Figs. 3 and 4 show cases where the switches SW1 and SW2 are switched simultaneously (i.e., at the same timing when one of the switches SW1 and SW2 is turned on and the other is turned off). However, there may be a time lag between switching of the switch SW1 and switching of the switch SW2.

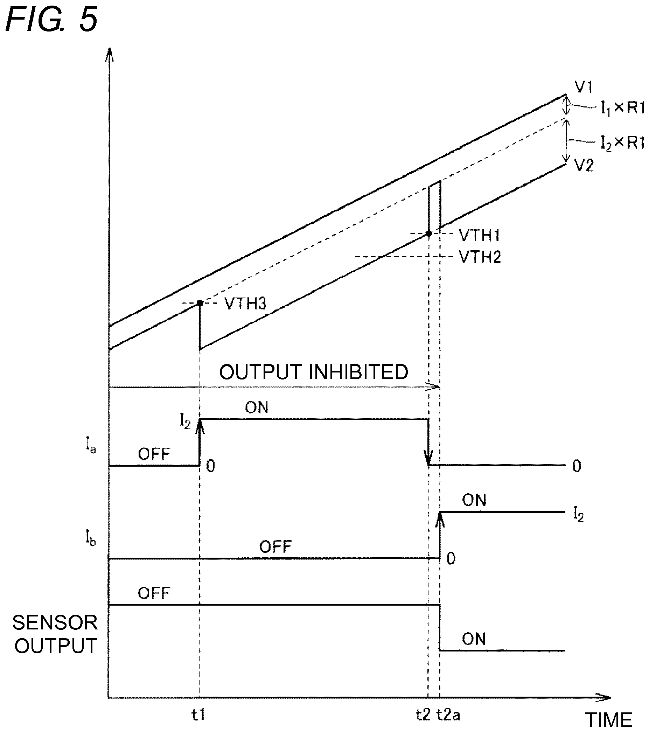

Fig. 5 is a timing diagram illustrating the operation of the sensor 101 during power-up in the case where a time lag exists between the operations of two switches SW1 and SW2. Referring to Fig. 5, changes in the voltages V1 and V2 up to time t2 are similar to the changes in the voltages V1 and V2 shown in Fig. 3. The voltage V2 reaches the threshold voltage VTH1 at time t2. The control circuit 11 first turns off the switch SW1. Accordingly, a period occurs in which the switch SW1 and the switch SW2 are both turned off. Since the current Ia (=I2) stops, the voltage V2 once rises from {V1 - (I1 + I2) × R1} to {V1 - (I1 × R1)}.

The control circuit 11 then turns on the switch SW2 at time t2a. This allows the current Ib (=I2) to flow, and the voltage V2 decreases from {V1 - (I1 × R1)} to {V1 - (I1 + I2) × R1}. Thus, when the voltage V2 rises, the control circuit 11 controls the switches SW1 and SW2 to increase the voltage V2 once. Here, since Ia = Ib = I2, the voltage V2 at time t2a is equal to the voltage V2 that is reached at time t2a in the case assuming no time lag is generated between the operations of the switches SW1 and SW2. That is, the voltage V2 is higher than the threshold voltage VTH1 at time t2a. This can prevent the power reset more reliably, thereby ensuring the normal operation of the sensor 101 after time t2a.

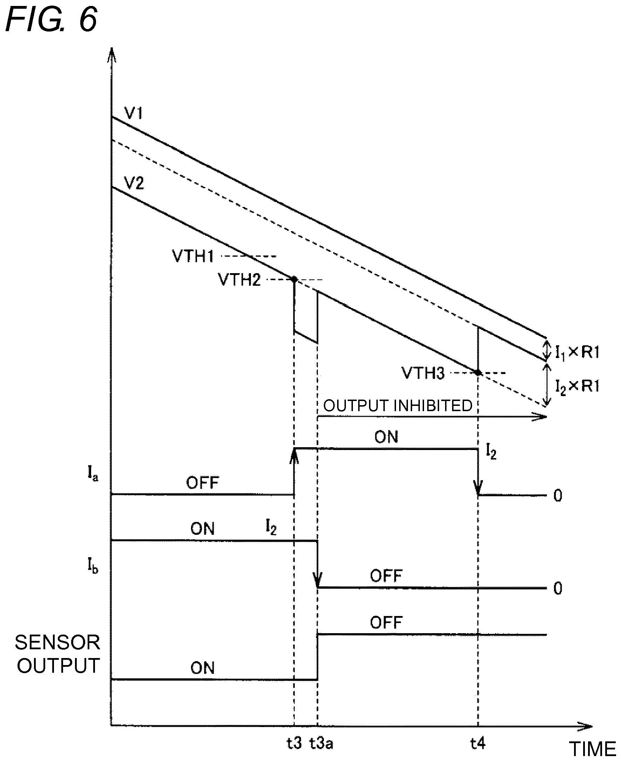

Fig. 6 is a timing diagram illustrating the operation of the sensor 101 during power-down in the case where a time lag exists between two switches SW1 and SW2. Referring to Fig. 6, changes in the voltages V1 and V2 up to time t3 are similar to the changes in the voltages V1 and V2 shown in Fig. 4. The voltage V2 reaches the threshold voltage VTH2 at time t3. The control circuit 11 first turns on the switch SW1, resulting in a state in which the switches SW1 and SW2 are both turned on. Thus, both currents Ia and Ib flow at time t3. The voltage V2 once decreases from {V1 - (I1 + I2) × R1} to {V1 - (I1 + 2I2) × R1)}.

The control circuit 11 then turns off the switch SW2 at time t3a, whereby the voltage V2 rises from {V1 -(I1 + 2I2) × R1)} to {V1 -(I1 + I2) × R1}. The voltage V2 decreases while maintaining a voltage drop of {(I1 + I2) × R1)} with respect to the voltage V1 for a period from time t3a to time t4. A subsequent change in the voltage V2 is similar to the change in the voltage V2 shown in Fig. 4, and the description thereof is not repeated hereinafter. Thus, when the voltage V2 decreases, the control circuit 11 controls the switches SW1 and SW2 to significantly reduce the voltage V2 once, thereby preventing the power re-reset more reliably.

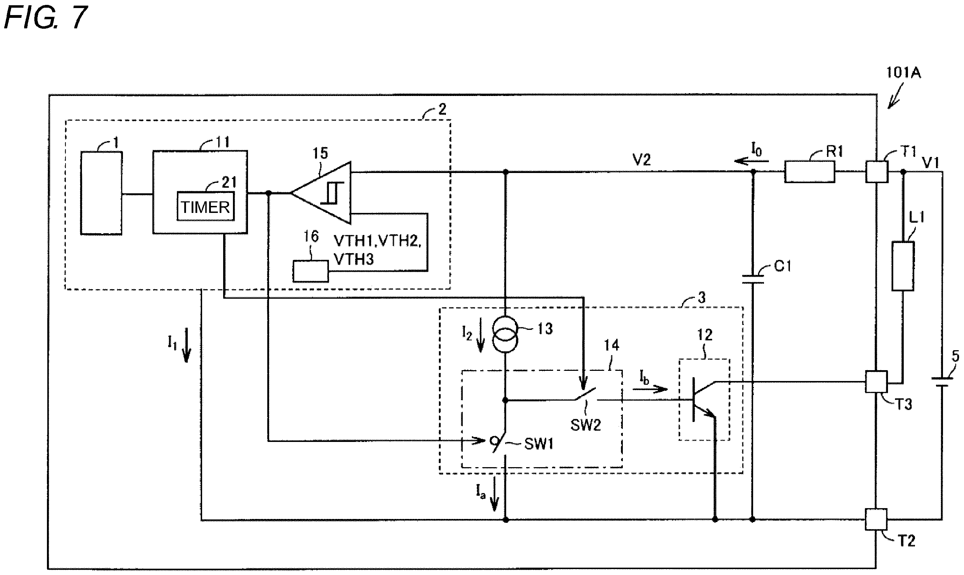

Fig. 7 is a diagram illustrating another exemplary configuration of the sensor of the first embodiment. Referring to Fig. 7, a sensor 101A is different from the sensor 101 shown in Fig. 2 in that the control circuit 11 has a timer 21. The other portions of the sensor 101A are configured similarly to the corresponding portions of the sensor 101, and the description thereof is not repeated hereinafter.

The timer 21 is started when the power supply 5 rises. Specifically, the timer 21 is started at the time when the voltage V2 has reached the threshold voltage VTH1. When the timer 21 measures a certain time, the control circuit 11 turns off the switch SW1 and turns on the switch SW2.

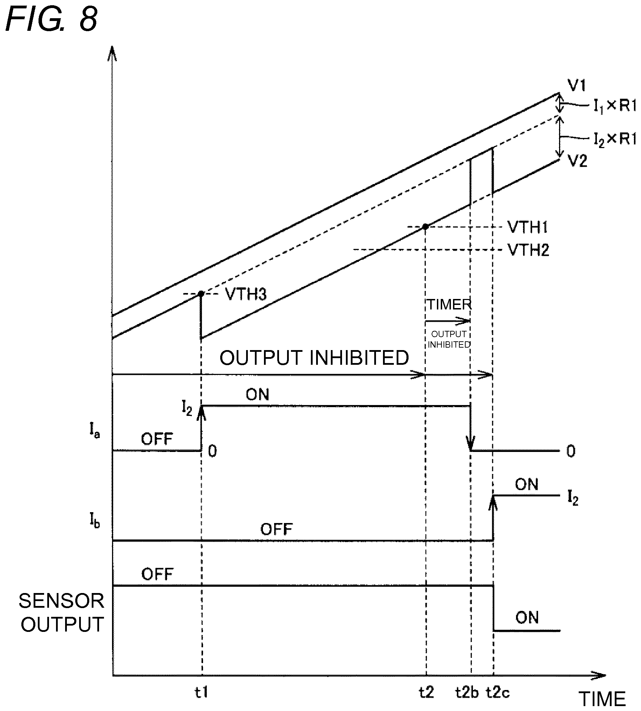

Fig. 8 is a timing diagram illustrating the operation of the sensor 101A shown in Fig. 7 during power-up. Referring to Fig. 8, changes in the voltages V1 and V2 up to time t2 are similar to the changes in the voltages V1 and V2 shown in Fig. 3 or 5. When the voltage V2 reaches the threshold voltage VTH1 at time t2, the timer 21 of the control circuit 11 starts to operate. While the timer 21 is running, the signal output from the control circuit 11 to the switches SW1 and SW2 is inhibited.

The timer 21 expires at time t2b (time is up), whereby the control circuit 11 turns off the switch SW1. The voltage V2 once rises from {V1 - (I1 + I2) × R1} to {V1 - (I1 × R1)}. The control circuit 11 then turns on the switch SW2 at time t2c. This allows the current Ib (=Ia) to flow, and the voltage V2 decreases from {V1 - (I1 × R1)} to {V1 - (I1 + I2) × R1}. The voltage V2 at this time is higher than the threshold voltage VTH1.

Thus, the control circuit 11 operates the switches SW1 and SW2 after a certain length period has elapsed from the time when the voltage V2 reached the threshold voltage VTH1. This can reliably prevent the voltage V2 from falling below the threshold voltage VTH1 by switching the switches SW1 and SW2 even if a time lag exists between the operations of the switches SW1 and SW2.

The operation of the sensor 101A during power-down is similar to the operation shown in Fig. 6, and the description thereof is not repeated hereinafter.

As described above, the first embodiment can prevent an error output (malfunction) of a sensor during power-up or power-down without depending on the rising or falling rate of the power supply used.

Since there is no need to increase the hysteresis width, the working voltage range of the sensor can be prevented from being narrower (i.e., the lower limit of the working voltage can be prevented from being higher).

In addition, the voltage drop across the resistor R1 may not be reduced. That is, there is no need to reduce the value of the resistor R1 or to provide additional components such as a surge absorber. Thus, the noise immunity can be enhanced using an inexpensive configuration.

### Second Embodiment

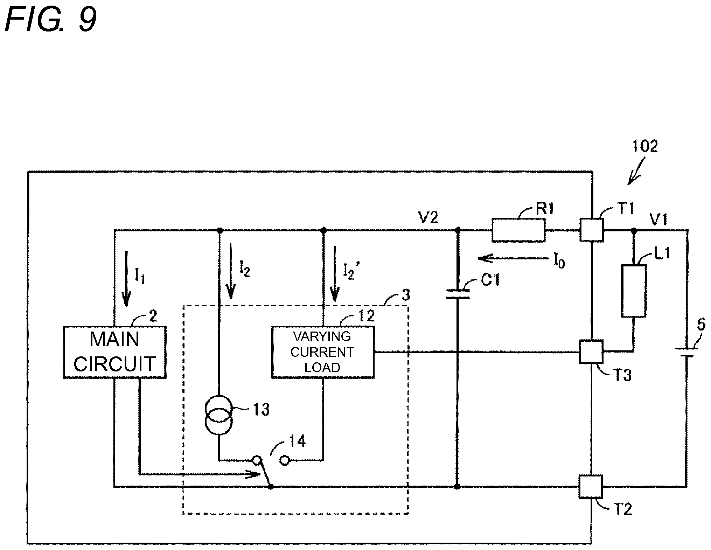

Fig. 9 is a block diagram showing a schematic configuration of a sensor of a second embodiment. Referring to Figs. 1 and 9, a sensor 102 of the second embodiment is different from the sensor 101 of the first embodiment in the arrangement of the switching circuit 14 and the current source 13. Specifically, in the second embodiment, the switching circuit 14 is configured to connect one of the current source 13 and the varying current load 12 to the ground terminal T2. Note that the switching circuit 14 is not connected to any of the current source 13 and the varying current load 12 until the voltage V2 reaches the threshold voltage VTH3. The second embodiment is similar to the first embodiment in this regard.

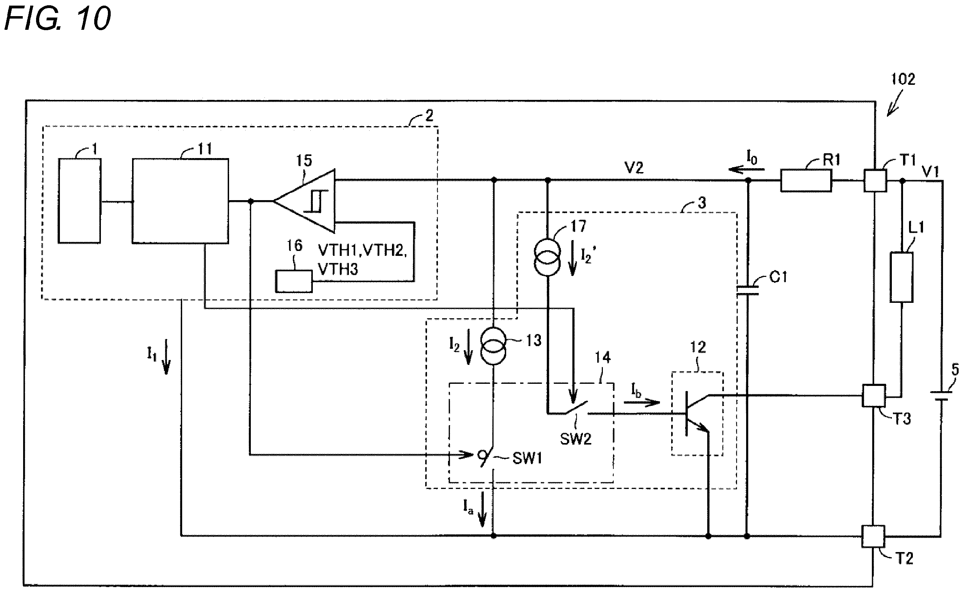

Fig. 10 is a diagram illustrating an example of a specific configuration of the circuit shown in Fig. 9. Referring to Figs. 2 and 10, the sensor 102 is different from the sensor 101 in that the output circuit 3 further includes a current source 17 and the switch SW2 is connected to the current source 17 instead of the current source 13. The current source 17 is configured to supply a constant current 12', where the current 12' is equal to the current 12.

The current source 13 is arranged between the resistor R1 and the ground terminal T2. The switch SW1 switches whether to connect the current source 13 to the ground terminal T2. The current source 17 is arranged between the resistor R1 and the varying current load 12 (drive circuit). The switch SW2 switches whether to connect the current source 17 to the varying current load 12. The other portions of the sensor 102 are configured similarly to the corresponding portions of the sensor 101, and the description thereof is not repeated hereinafter.

The operation of the sensor 102 of the second embodiment during power-up and power-down, i.e., the control of the switches SW1 and SW2 using the control circuit 11, is similar to the control of the first embodiment. The switch SW1 is turned off and the switch SW2 is turned on in a state (first state) in which the varying current load 12 drives the load L1, while the switch SW1 is turned on and the switch SW2 is turned off in a state (second state) in which the constant current flows to the ground. The current 12' is equal to the current 12 as described above. The switch SW1 is turned off and the switch SW2 is turned on, whereby the current consumption 10 of the sensor 102 is maintained at (I1 + I2). Note that the current 12 may be greater than the drive current, i.e., the current 12'.

As with the first embodiment, the control circuit 11 of the sensor 102 may be provided with a timer (see Fig. 7). In this case, changes in the voltages V1 and V2 are similar to the changes in the voltages V1 and V2 shown in Fig. 8. A time lag may exist between the operations of the switches SW1 and SW2. In this case, changes in the voltages V1 and V2 are similar to the changes in the voltages V1 and V2 shown in Figs. 5 and 6. In addition, the control circuit 11 may be provided with a timer, and a time lag may exist between the operations of the switches SW1 and SW2.

According to the second embodiment, the main circuit 2 cancels the current variation by switching between the driving and stopping of the sensor 102. The second embodiment can therefore obtain an effect similar to the first embodiment.

### Third Embodiment

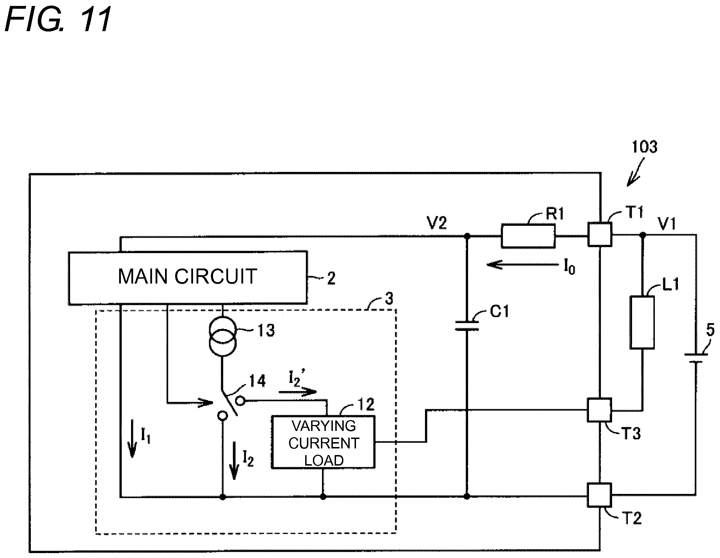

Fig. 11 is a block diagram showing a schematic configuration of a sensor of a third embodiment. Referring to Figs. 1 and 11, the sensor 103 of the third embodiment is configured such that diverted part of the current 10 flowing through the main circuit 2 flows through the varying current load 12. Specifically, the current source 13 is connected to the main circuit 2. The switching circuit 14, which is controlled by the main circuit 2, switches whether to pass the current from the current source 13 to the ground terminal T2 or to supply it through the varying current load 12.

When the switching circuit 14 connects the current source 13 and the ground terminal T2, the current 12 flows from the current source 13 to the ground terminal T2, without flowing through the varying current load 12. This state corresponds to the "second state" described above.

On the other hand, when the switching circuit 14 connects the current source 13 and the varying current load 12, the current 12' flows from the current source 13 through the varying current load 12 to the ground terminal T2. This state corresponds to the "first state" described above, where 12' = 12. Thus, the current consumption of the sensor 103 is maintained to be (I1 + I2).

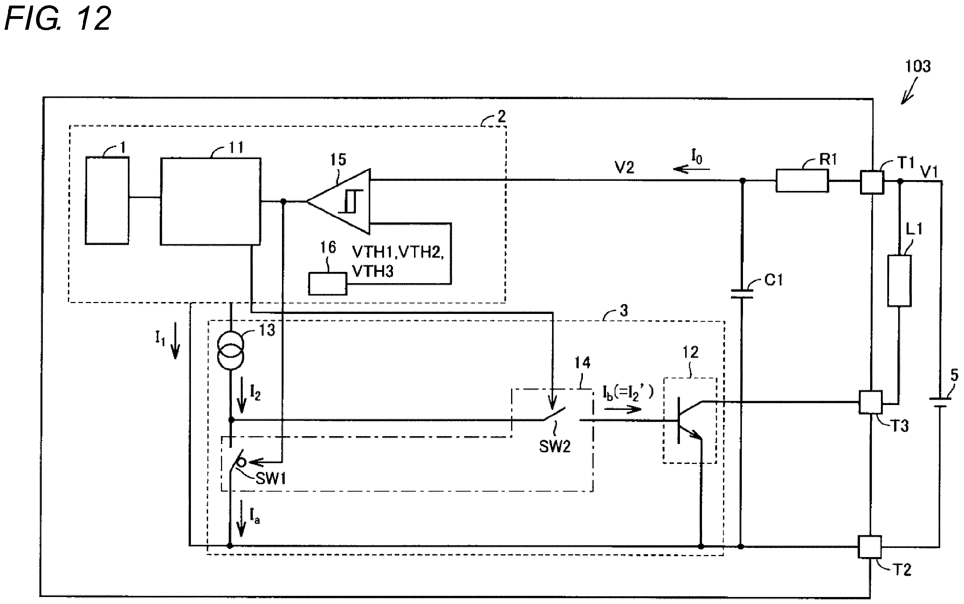

Fig. 12 is a diagram illustrating an example of a specific configuration of the circuit shown in Fig. 11. Referring to Figs. 2 and 12, the current source 13 is connected to the main circuit 2. The third embodiment differs from the first embodiment in this regard.

Changes in the voltages V1 and V2 of the sensor 103 during power-up are similar to the changes in the voltages V1 and V2 shown in Fig. 3 or 5, while changes in the voltages V1 and V2 of the sensor 103 during power-down are similar to the changes in the voltages V1 and V2 shown in Fig. 4 or 6.

As with the first embodiment, the control circuit 11 of the sensor 103 may be provided with a timer. In this case, changes in the voltages V1 and V2 during power-down are similar to the changes in the voltages V1 and V2 shown in Fig. 7.

According to the third embodiment, since part of the circuit current 10 is the current Ib when the output of the sensor 103 is turned on, no change occurs in the current consumption of the entire circuit. This allows the voltage V2 to increase monotonically during power-up. That is, once the voltage V2 has passed through the hysteresis width, the voltage V2 is inhibited from returning to the hysteresis width. Thus, the sensor 103 can be prevented from producing an error output. Once the voltage V2 has passed through the hysteresis width during power-down, the voltage V2 is also inhibited from returning to the hysteresis width (i.e., the voltage V2 is inhibited from rising once). Thus, the sensor 103 can be prevented from producing an error output.

According to the third embodiment, part of the current from the main circuit 2 is reused as a current to cancel the current variation. Accordingly, extra current consumption can be reduced.

### Fourth Embodiment

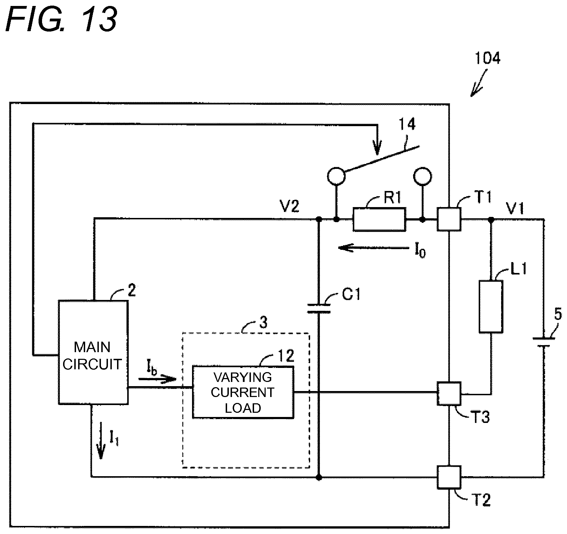

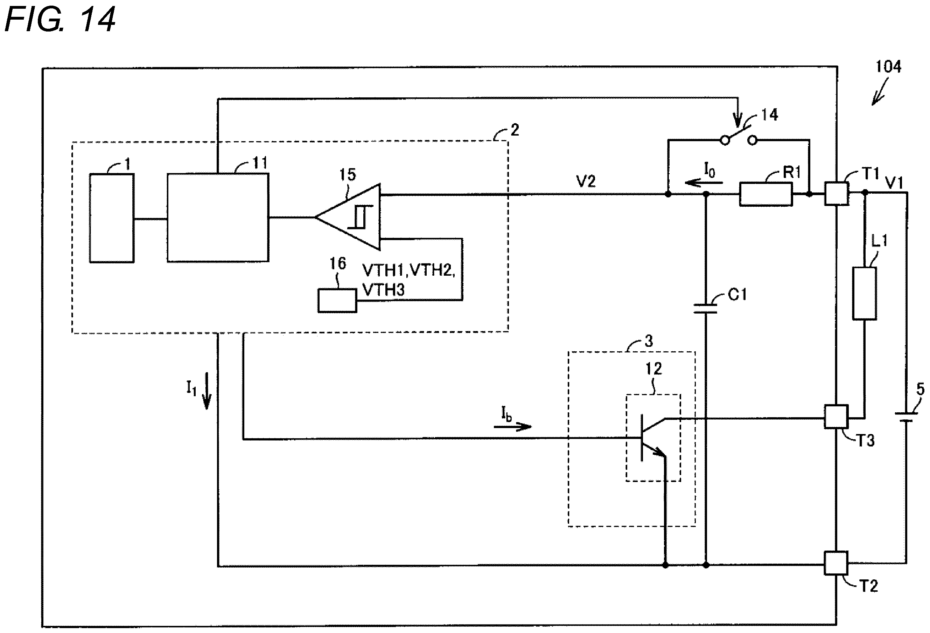

Fig. 13 is a block diagram showing a schematic configuration of a sensor of a fourth embodiment. Fig. 14 is a diagram illustrating an example of a specific configuration of the circuit shown in Fig. 13. Referring to Figs. 13 and 14, a sensor 104 of the fourth embodiment is different from the sensor 101 in that the current source 13 is omitted and the switching circuit 14 is connected to both ends of the resistor R1. The switching circuit 14, which is controlled by the main circuit 2, short-circuits both ends of the resistor R1.

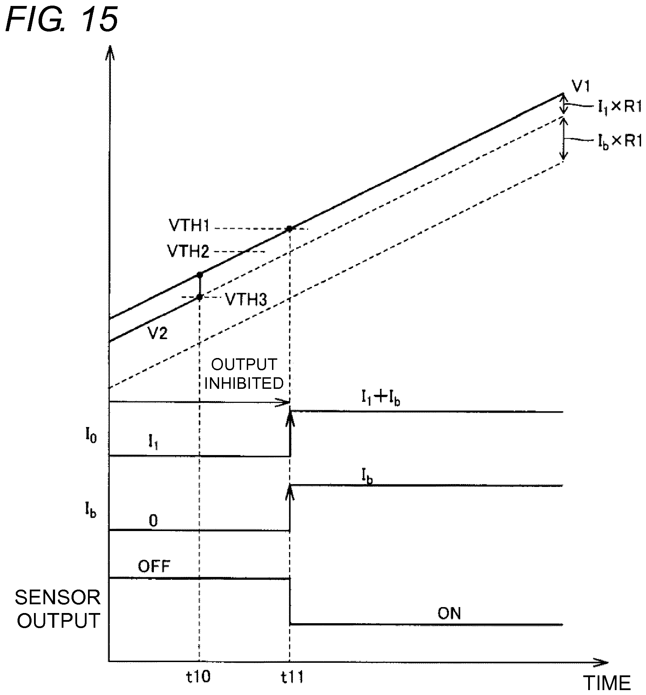

Fig. 15 is a timing diagram illustrating the operation of the sensor 103 shown in Fig. 14 during power-up. Referring to Fig. 15, the current consumption 10 of the sensor 104 is equal to I1 in the early stage. The voltage V2 is therefore lower than the voltage V1 by (I1 × R1).

The voltage V2 reaches the threshold voltage VTH3 at time t10. This allows the control circuit 11 to turn on the switching circuit 14. Thus, the voltage V2 corresponds to the voltage V1.

The voltage V2 (= V1) reaches the threshold voltage VTH1 at time t11, thereby allowing the sensor 103 to become output-enabled. Accordingly, the current Ib is supplied to the base of the NPN transistor (varying current load 12). The current consumption 10 of the sensor 104 after time t11 is (I1 + Ib). Thus, the control circuit 11 turns on the switching circuit 14 at a minimum drive voltage VTH3 to short-circuit the both ends of the resistor R1. No voltage drop occurs across the resistor R1 at the threshold voltage VTH1 when driving an output current, resulting in V2 = V1. This prevents the voltage V2 from falling below the threshold voltage VTH2, thus preventing the sensor 104 from producing an error output. Note that the switching circuit 14 may be opened after the voltage V1 has risen sufficiently.

### Fifth Embodiment

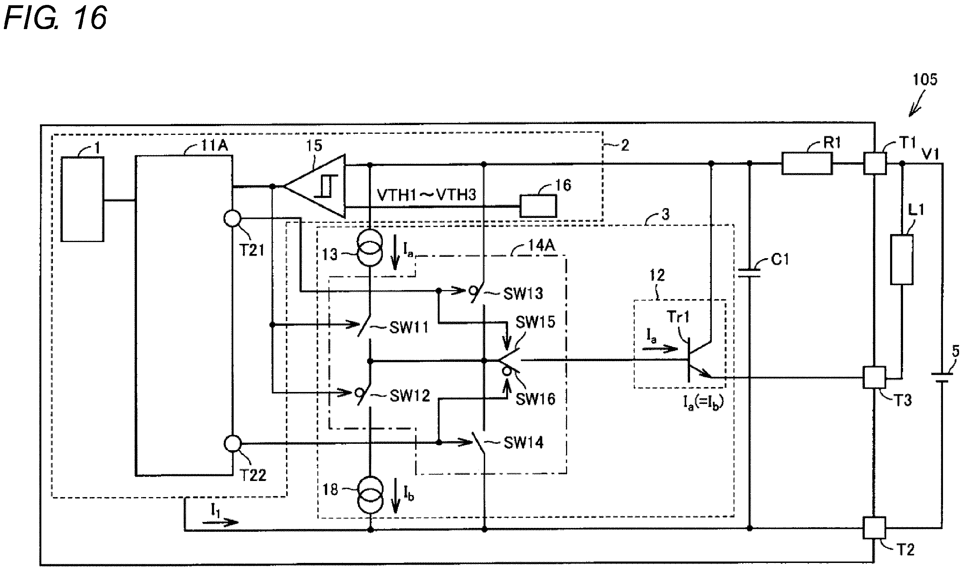

Fig. 16 is a block diagram showing a schematic configuration of a sensor of a fifth embodiment. Referring to Figs. 1 and 16, a sensor 105 of the fifth embodiment is different from the sensor 101 in that the sensor 105 is provided with a control circuit 11A instead of the control circuit 11 and provided with a switching circuit 14A instead of the switching circuit 14, and is further provided with a current source 18. An NPN transistor Tr1 is used as the varying current load 12.

The control circuit 11A has current control terminals T21 and T22. T21 is a current control terminal for the NPN transistor, and T22 is a current control terminal for the PNP transistor.

The switching circuit 14A includes switches SW11, SW12, SW13, SW14, SW15, and SW16. The switches SW11 and SW12 are connected in series between the current sources 13 and 18, and are turned on or off in response to the output of the hysteresis comparator 15. The switches SW13 and SW15 are turned on or off in response to an output signal from the current control terminal T21, while the switches SW14 and SW16 are turned on or off in response to an output signal from the current control terminal T22.

The current source 13 is configured to supply a constant current Ia. The current source 18 is configured to supply a constant current Ib. The current Ia flowing through the current source 13 is equal to the current Ib flowing through the current source 18. In addition, the currents Ia and Ib are equal to a current flowing through the varying current load 12 (i.e., base current of the NPN transistor Tr1).

The operation of the sensor 105 is basically similar to the operation of the sensor 101. The operation of the sensor 105 will be described with reference to Figs. 3 and 16. All of the switches SW12, SW13, and SW15 are turned off until the voltage V2 reaches the threshold voltage VTH3. In this case, the current consumption 10 of the sensor 105 is equal to the current I1 flowing through the control circuit 11A. Thus, the voltage V2 is lower than the voltage V1 by (I1 × R1).

The voltage V2 reaches the threshold voltage VTH3. The output of the hysteresis comparator 15 turns on the switch SW12. The control circuit 11A outputs a signal to turn on the switch SW13 from the current control terminal T21. The signal to turn on the switch SW13 is also a signal to turn off the switch SW15. Thus, the switch SW15 is turned off, and the current Ib flows through the switches SW13 and SW12 to the ground line. This state corresponds to the "second state" described above.

The voltage V2 then reaches the threshold voltage VTH1. In this case, the output of the hysteresis comparator 15 turns off the switch SW12 and turns on the switch SW11. The control circuit 11A outputs a signal to turn off the switch SW13 from the current control terminal T21. The signal to turn off the switch SW13 is also a signal to turn on the switch SW15. Thus, the switch SW15 is turned on, and the current Ia flowing through the base of the NPN transistor Tr1 drives the NPN transistor Tr1 . This state corresponds to the "first state" described above. The current consumption of the sensor 105 does not change even if each of the switches SW11, SW14, and SW16 is switched. This prevents the voltage V2 from falling below the threshold voltage VTH2. Thus, the sensor 105 can be prevented from producing an error output.

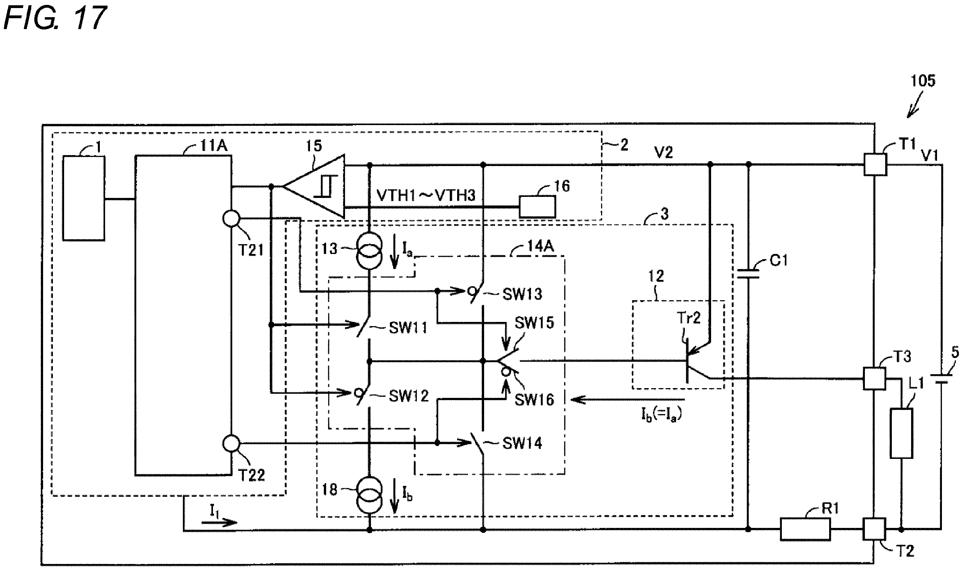

Fig. 17 is a block diagram illustrating the operation of the sensor 105 in the case where a PNP transistor Tr2 is used as the varying current load 12. Referring to Fig. 17, the load L1 is connected between the output terminal T3 and the ground terminal T2, and the resistor R1 is inserted into the ground line.

The operation of the sensor 105 will be described with reference to Figs. 4 and 17. All of the switches SW11, SW14, and SW16 are turned off until the voltage V2 reaches the threshold voltage VTH3. In this case, the current consumption 10 of the sensor 105 is equal to the current I1 flowing through the control circuit 11A. Accordingly, the voltage V2 is lower than the voltage V1 by (I1 × R1).

The voltage V2 then reaches the threshold voltage VTH3. The output of the hysteresis comparator 15 turns on the switch SW11. The control circuit 11A outputs a signal to turn on the switch SW14 from the current control terminal T22. The signal to turn on the switch SW14 is also a signal to turn off the switch SW16. Thus, the switch SW16 is turned off, and the current Ia flows from the current source 13 through the switches SW11 and SW14 to the ground line. This state corresponds to the "second state" described above.

The voltage V2 then reaches the threshold voltage VTH1. In this case, the output of the hysteresis comparator 15 turns off the switch SW11 and turns on the switch SW12. The control circuit 11A outputs a signal to turn off the switch SW14 from the current control terminal T22. The signal to turn off the switch SW14 is also a signal to turn on the switch SW16. Thus, the switch SW16 is turned on. This allows the current Ib (base current) to flow from the base of the PNP transistor Tr2 through the switches SW12 and SW16 to the ground line, and the PNP transistor Tr2 is driven. This state corresponds to the "first state" described above. As described above, the current Ib is equal to the current Ia. This prevents the voltage V2 from falling below the threshold voltage VTH2, thereby preventing the sensor 105 from producing an error output.

Thus, according to the fifth embodiment, the control circuit having a single configuration can drive the varying current load even if the varying current load is an NPN transistor or a PNP transistor. This increases the convenience of using the sensor.

It should be understood that embodiments described herein are merely exemplary in all respects and are not limited thereto. The scope of the present invention is defined by the appended claims and not by the description above, and is intended to cover all modifications within the meaning and the scope equivalent to the claims.

## Claims

1. A sensor (101, 101A, 102, 103, 104, 105, 200) comprising:
a main circuit (2, 202) configured to detect a detection target;
a noise filter comprising a resistor (R1) connected between the main circuit (2, 202) and a power supply (5); and
an output circuit (3, 203) configured to be driven by the main circuit (2, 202) and to generate a sensor output indicating presence or absence of the detection target,
the output circuit (3, 203) comprising:
a drive circuit (12) configured to generate the sensor output to drive an external load (L1) outside of the sensor (101, 101A, 102, 103, 104, 105, 200) in response to a drive current that flows from the power supply (5) through the resistor (R1) 2. into the drive circuit;
a current source (13, 213, 17, 18) configured to generate a constant current equal to or more than the drive current, a first terminal of the current source being connected to a first terminal of the resistor (R1) that is connected to the main circuit; and
a switching circuit (14, 214) configured to switch between a first state in which the drive circuit (12) drives the external load (L1) in response to the drive current and a second state in which the constant current flows from the power supply (5) through the resistor (R1) and the current source (13, 18) to a ground, the switching circuit (14, 214) being controlled by the main circuit (2, 202), wherein upon rise of an voltage input to the main circuit (2, 202) at the first terminal of the resistor (R1), the main circuit (2, 202) switches the switching circuit (14, 214) from the second state to the first state when the input voltage exceeds a first voltage,
upon fall of the input voltage, the main circuit (2, 202) switches the switching circuit (14, 214) from the first state to the second state when the input voltage falls below a second voltage lower than the first voltage,
the switching circuit (14, 214) comprises:
a first switch (SW1) configured to selectively connect a second terminal of the current source (13, 18) to the ground, and
a second switch (SW2) configured to selectively connect the second terminal of the current source (13, 213, 17, 18) to the drive circuit (12), and
the main circuit (2, 202) turns off the first switch (SW1) and turns on the second switch (SW2) such that the current source (13, 213, 17, 18) is connected to the drive circuit (12) in the first state, whereas the main circuit (2, 202) turns on the first switch (SW1) and turns off the second switch (SW2) such that the current source (13, 18) is connected to the ground in the second state.

2. The sensor (101, 101A, 102, 103, 104, 105, 200) according to claim 1, wherein
the main circuit (2, 202) sets the switching circuit (14, 214) to a third state in which the drive current does not flow through the drive circuit (12) and the constant current does not flow through the current source (13, 18) from starting of the rise of the input voltage until the input voltage reaches a third voltage lower than the second voltage, and after the input voltage has reached the third voltage at the fall of the input voltage.

3. The sensor (101, 101A, 102, 103, 104, 105, 200) according to any one of claims 1 to 2, wherein the current source (13, 213, 17, 18) comprises
a first current source (13, 18) disposed between the resistor (R1) and the ground, and
a second current source (13, 17, 213) configured to generate the drive current, the second current source being disposed between the resistor (R1) and the drive circuit (12),
wherein the first switch (SW1) is configured to selectively connect the first current source to the ground, and
the second switch (SW2) is configured to selectively connect the second current source to the drive circuit (12).

4. The sensor (101, 101A, 102, 103, 104, 105, 200) according to any one of claims 1 to 3, wherein the main circuit (2, 202) turns off the first switch (SW1) and then turns on the second switch (SW2) after a certain time has elapsed from when the input voltage exceeded the first voltage.

5. The sensor (101, 101A, 102, 103, 104, 105, 200) according to claim 1, wherein
the current source (13) supplies part of the current output from the main circuit (2, 202) as the constant current, and
the switching circuit (14, 214) connects the current source (13) and the drive circuit (12) such that the constant current is supplied to the drive circuit (12) as the drive current in the first state, and the switching circuit (14, 214) connects the current source (13) and the ground such that the constant current flows to the ground in the second state.

6. The sensor (105) according to claim 1, wherein the drive circuit (12) comprises one of an NPN transistor and a PNP transistor,
the current source (13, 18) comprises
a first current source (13) configured to supply a current to a base of the NPN transistor as the drive current if the transistor of the drive circuit (12) is the NPN transistor, and
a second current source (18) configured to generate a base current flowing from a base of the PNP transistor to the ground as the drive current if the transistor of the drive circuit (12) is the PNP transistor, and
if the transistor of the drive circuit (12) is the NPN transistor, the switching circuit (14A) supplies the drive current from the first current source (13) to the base of the NPN transistor in the first state, and the switching circuit (14A) passes the current from the first current source (13) to the ground in the second state, and
if the transistor of the drive circuit (12) is the PNP transistor, the switching circuit (14A) passes the drive current from the base of the PNP transistor to the ground in the first state, and the switching circuit (14A) passes the current from the second current source (18) to the ground in the second state.

## Patentansprüche

1. Sensor (101, 101A, 102, 103, 104, 105, 200) aufweisend:
eine Hauptschaltung (2, 202), die eingerichtet ist, ein zu detektierendes Objekt zu detektieren;
einen Rauschfilter mit einem Widerstand (R1), der zwischen der Hauptschaltung (2, 202) und einer Stromversorgung (5) vorgesehen ist; und
eine Ausgabeschaltung (3, 203), die eingerichtet ist, von der Hauptschaltung (2, 202) angesteuert zu werden und eine Sensorausgabe zu erzeugen, die das Vorhandensein des zu detektierendes Objekts anzeigt,
wobei die Ausgabeschaltung (3, 203) Folgendes aufweist:
eine Treiberschaltung (12), die eingerichtet ist, die Sensorausgabe zu erzeugen, um eine externe Last (L1) außerhalb des Sensors (101, 101A, 102, 103, 104, 105, 200) in Antwort auf einen Betriebsstrom anzusteuern, der von der Stromversorgung (5) durch den Widerstand (R1) in die Treiberschaltung fließt;
eine Stromquelle (13, 213, 17, 18), die eingerichtet ist, einen konstanten Strom zu erzeugen, der gleich oder größer als der Betriebsstrom ist, wobei ein erster Anschluss der Stromquelle mit einem ersten Anschluß des Widerstands (R1) verbunden ist, der mit der Hauptschaltung verbunden ist; und
eine Umschaltschaltung (14, 214), die eingerichtet ist, zwischen einem ersten Zustand, in welchem die Treiberschaltung (12) die externe Last (L1) in Antwort auf den Betriebsstrom treibt, und einem zweiten Zustand, in welchem der konstante Strom von der Stromversorgung (5) durch den Widerstand (R1) und die Stromquelle (13, 18) zu Masse fließt, umzuschalten, wobei die Umschaltschaltung (14, 214) durch die Hauptschaltung (2, 202) gesteuert wird, wobei
die Hauptschaltung (2, 202) bei einem Anstieg einer Spannungseingabe in der Hauptschaltung (2, 202) am ersten Anschluss des Widerstands (R1) die Umschaltschaltung (14, 214) von dem zweiten Zustand in den ersten Zustand umschaltet, wenn die Eingabespannung eine erste Spannung übersteigt,
die Hauptschaltung (2, 202) bei einem Abfallen der Spannungseingabe die Umschaltschaltung (14, 214) vom ersten Zustand in den Zustand umschaltet, wenn die Eingabespannung unter eine zweite Spannung fällt, die niedriger als die erste Spannung ist, und
die Umschaltschaltung (14, 214) Folgendes aufweist:
einen ersten Schalter (SW1), der eingerichtet ist, einen zweiten Anschluss der Stromquelle (13, 18) wahlweise mit Masse zu verbinden, und
einen zweiten Schalter (SW2), der eingerichtet ist, den zweiten Anschluss der Stromquelle (13, 213, 17, 18) wahlweise mit der Treiberschaltung (12) zu verbinden, und
die Hauptschaltung (2, 202) im ersten Zustand den ersten Schalter (SW1) ausschaltet und den zweiten Schalter (SW2) einschaltet, so dass die Stromquelle (13, 213, 17, 18) mit der Treiberschaltung (12) verbunden ist, und die Hauptschaltung (2, 202) im zweiten Zustand den ersten Schalter (SW1) einschaltet und den zweiten Schalter (SW2) ausschaltet, so dass die Stromquelle (13, 18) mit Masse verbunden ist.

2. Sensor (101, 101A, 102, 103, 104, 105, 200) gemäß Anspruch 1, wobei
die Hauptschaltung (2, 202) die Umschaltschaltung (14, 214) in einen dritten Zustand versetzt, in welchem der Betriebsstrom nicht durch die Treiberschaltung (12) fließt und der konstante Strom nicht durch die Stromquelle (13, 18) fließt, und zwar ab dem Beginn des Anstiegs der Eingabespannung bis die Eingabespannung eine dritter Spannung erreicht, die niedriger als die zweite Spannung ist, und nachdem die Eingabespannung die dritte Spannung bei einem Abfall der Eingabespannung erreicht.

3. Sensor (101, 101A, 102, 103, 104, 105, 200) gemäß einem der Ansprüche 1 bis 2, wobei
die Stromquelle (13, 213, 17, 18) Folgendes aufweist:
eine erste Stromquelle (13, 18), die zwischen dem Widerstand (R1) und Masse angeordnet ist, und
eine zweite Stromquelle (13, 17, 213), die den Betriebsstrom erzeugt, wobei die zweite Stromquelle zwischen dem Widerstand (R1) und der Treiberschaltung (12) vorgesehen ist,
wobei der erste Schalter (SW1) eingerichtet ist, die erste Stromquelle wahlweise mit Masse zu verbinden, und
der zweite Schalter (SW2) eingerichtet ist, die zweite Stromquelle wahlweise mit der Treiberschaltung (12) zu verbinden.

4. Sensor (101, 101A, 102, 103, 104, 105, 200) gemäß einem der Ansprüche 1 bis 3, wobei
die Hauptschaltung (2, 202) den ersten Schalter (SW1) ausschaltet und dann den zweiten Schalter (SW2) nach Ablauf einer bestimmten Zeit ab dem Übersteigen der ersten Spannung durch die Eingabespannung einschaltet.

5. Sensor (101, 101A, 102, 103, 104, 105, 200) gemäß Anspruch 1, wobei
die Stromquelle (13) einen Teil des Ausgabestroms von der Hauptschaltung (2, 202) als konstanten Strom bereitstellt, und
die Umschaltschaltung (14, 214) die Stromquelle (13) und die Treiberschaltung (12) so verbindet, dass der konstante Strom an der Treiberschaltung (12) im ersten Zustand als Betriebsstrom bereitgestellt wird, und die Umschaltschaltung (14, 214) die Stromquelle (13) mit Masse verbindet, so dass der konstante Strom im zweiten Zustand an Masse fließt.

6. Sensor (105) gemäß Anspruch 1, wobei
die Treiberschaltung (12) einen NPN-Transistor oder einen PNP-Transistor aufweist, und
die Stromquelle (13, 18) Folgendes aufweist:
eine erste Stromquelle (13), die eingerichtet ist, einen Strom als Betriebsstrom an eine Basis des NPN-Transistors bereitzustellen, falls der Transistor der Treiberschaltung (12) ein NPN-Transistor ist, und
eine zweite Stromquelle (18), die eingerichtet ist, einen Basisstrom zu erzeugen, der von einer Basis des PNP-Transistors zu Masse fließt, als Betriebsstrom bereitzustellen, falls der Transistor der Treiberschaltung (12) ein PNP-Transistor ist, und
falls der Transistor der Treiberschaltung (12) ein NPN-Transistor ist, stellt die Umschaltschaltung (14A) im ersten Zustand den Betriebsstrom von der ersten Stromquelle (13) an der Basis des NPN-Transistors bereit, und die Umschaltschaltung (14A) lässt den Strom von der ersten Stromquelle (13) im zweiten Zustand an Masse fließen, und
falls der Transistor der Treiberschaltung (12) ein PNP-Transistor ist, lässt die Umschaltschaltung (14A) im ersten Zustand den Betriebsstrom von der Basis des PNP-Transistors an Masse fließen, und die Umschaltschaltung (14A) lässt den Strom von der zweiten Stromquelle (18) im zweiten Zustand an Masse fließen.

## Revendications

1. Capteur (101, 101A, 102, 103, 104, 105, 200) comprenant :
un circuit principal (2, 202) conçu pour détecter une cible de détection ;
un filtre antiparasite comprenant une résistance (R1) connectée entre le circuit principal (2, 202) et une alimentation électrique (5) ; et
un circuit de sortie (3, 203) conçu pour être attaqué par le circuit principal (2, 202) et pour produire une sortie de capteur indiquant la présence ou l'absence de la cible de détection,
le circuit de sortie (3, 203) comprenant :
un circuit d'attaque (12) conçu pour produire la sortie de capteur afin d'attaquer une charge externe (L1) à l'extérieur du capteur (101, 101A, 102, 103, 104, 105, 200), en réponse à un courant d'attaque qui circule de l'alimentation électrique (5) au circuit d'attaque, en passant par la résistance (R1) ;
une source de courant (13, 213, 17, 18) conçue pour produire un courant constant supérieur ou égal au courant d'attaque, une première borne de la source de courant étant connectée à une première borne de la résistance (R1) qui est connectée au circuit principal ; et
un circuit de commutation (14, 214) conçu pour commuter entre un premier état dans lequel le circuit d'attaque (12) attaque la charge externe (L1) en réponse au courant d'attaque et un deuxième état dans lequel le courant constant circule de l'alimentation électrique (5) vers la terre, en passant par la résistance (R1) et la source de courant (13, 18), le circuit de commutation (14, 214) étant commandé par le circuit principal (2, 202), dans lequel :
lors de l'augmentation d'une tension appliquée au circuit principal (2, 202) au niveau de la première borne de la résistance (R1), le circuit principal (2, 202) commute le circuit de commutation (14, 214) du deuxième état au premier état, lorsque la tension d'entrée dépasse une première tension,
lors de la chute de la tension d'entrée, le circuit principal (2, 202) commute le circuit de commutation (14, 214) du premier état au deuxième état, lorsque la tension d'entrée chute au-dessous d'une deuxième tension inférieure à la première tension,
le circuit de commutation (14, 214) comprend :
un premier interrupteur (SW1) conçu pour connecter de manière sélective une seconde borne de la source de courant (13, 18) à la terre, et
un second interrupteur (SW2) conçu pour connecter de manière sélective la seconde borne de la source de courant (13, 213, 17, 18) au circuit d'attaque (12) ; et le circuit principal (2, 202) arrête le premier interrupteur (SW1) et enclenche le second interrupteur (SW2), de manière que la source de courant (13, 213, 17, 18) soit connectée au circuit d'attaque (12) dans le premier état, tandis que le circuit principal (2, 202) enclenche le premier interrupteur (SW1) et arrête le second interrupteur (SW2), de manière que la source de courant (13, 18) soit connectée à la terre dans le deuxième état.

2. Capteur (101, 101A, 102, 103, 104, 105, 200) selon la revendication 1, dans lequel :
le circuit principal (2, 202) met le circuit de commutation (14, 214) dans un troisième état dans lequel le courant d'attaque ne circule pas à travers le circuit d'attaque (12) et le courant constant ne circule pas à travers la source de courant (13, 18) depuis le début de l'augmentation de la tension d'entrée jusqu'à ce que la tension d'entrée atteigne une troisième tension inférieure à la deuxième tension, et après que la tension d'entrée a atteint la troisième tension à la chute de la tension d'entrée.

3. Capteur (101, 101A, 102, 103, 104, 105, 200) selon l'une quelconque des revendications 1 et 2 dans lequel :
la source de courant (13, 213, 17, 18) comprend :
une première source de courant (13, 18) disposée entre la résistance (R1) et la terre, et
une seconde source de courant (13, 17, 213) conçue pour produire le courant d'attaque, la seconde source de courant étant disposée entre la résistance (R1) et
le circuit d'attaque (12),
dans lequel le premier interrupteur (SW1) est conçu pour connecter de manière sélective la première source de courant à la terre, et
le second interrupteur (SW2) est conçu pour connecter de manière sélective la seconde source de courant au circuit d'attaque (12).

4. Capteur (101, 101A, 102, 103, 104, 105, 200) selon l'une quelconque des revendications 1 à 3 dans lequel :
le circuit principal (2, 202) arrête le premier interrupteur (SW1), puis enclenche le second interrupteur (SW2) après qu'un certain temps s'est écoulé depuis que la tension d'entrée a dépassé la première tension.

5. Capteur (101, 101A, 102, 103, 104, 105, 200) selon la revendication 1, dans lequel :
la source de courant (13) fournit une partie du courant délivré en provenance du circuit principal (2, 202) en tant que courant constant, et le circuit de commutation (14, 214) connecte la source de courant (13) et le circuit d'attaque (12), de manière que le courant constant soit fourni au circuit d'attaque (12) en tant que courant d'attaque dans le premier état, et le circuit de commutation (14, 214) connecte la source de courant (13) et la terre, de manière que le courant constant circule vers la terre dans le deuxième état.

6. Capteur (105) selon la revendication 1, dans lequel :
le circuit d'attaque (12) comprend soit un transistor NPN soit un transistor PNP, la source de courant (13, 18) comprend :
une première source de courant (13) conçue pour fournir un courant à une base du transistor NPN en tant que courant d'attaque, si le transistor du circuit d'attaque (12) est le transistor NPN, et
une seconde source de courant (18) conçue pour produire un courant de base circulant depuis une base du transistor PNP vers la terre, en tant que courant d'attaque, si le transistor du circuit d'attaque (12) est le transistor PNP, et
si le transistor du circuit d'attaque (12) est le transistor NPN, le circuit de commutation (14A) fournit le courant d'attaque, de la première source de courant (13) à la base du transistor NPN dans le premier état, et le circuit de commutation (14A) fait passer le courant, de la première source de courant (13) à la terre dans le deuxième état, et
si le transistor du circuit d'attaque (12) est le transistor PNP, le circuit de commutation (14A) fait passer le courant d'attaque, de la base du transistor PNP à la terre dans le premier état, et le circuit de commutation (14A) fait passer le courant, de la seconde source de courant (18) à la terre dans le deuxième état.
